(19) **Europäisches Patentamt**

**European Patent Office**

**Office européen des brevets**

(11) **EP 0 962 015 B1**

(12) **EUROPÄISCHE PATENTSCHRIFT**

(45) Veröffentlichungstag und Bekanntmachung des Hinweises auf die Patenterteilung:
**29.08.2001   Patentblatt 2001/35**

(51) Int Cl.$^7$: **G10L 19/00**

(21) Anmeldenummer: **97951997.2**

(22) Anmeldetag: **28.11.1997**

(86) Internationale Anmeldenummer:
**PCT/EP97/06633**

(87) Internationale Veröffentlichungsnummer:
**WO 98/37544 (27.08.1998 Gazette 1998/34)**

(54) **VERFAHREN UND VORRICHTUNGEN ZUM CODIEREN VON DISKRETEN SIGNALEN BZW. ZUM DECODIEREN VON CODIERTEN DISKRETEN SIGNALEN**

METHOD AND DEVICES FOR CODING DISCRETE SIGNALS OR FOR DECODING CODED DISCRETE SIGNALS

PROCEDE ET DISPOSITIFS DE CODAGE DE SIGNAUX DISCRETS OU DE DECODAGE DE SIGNAUX DISCRETS CODES

(84) Benannte Vertragsstaaten:
**AT BE CH DE DK ES FI FR GB GR IE IT LI LU MC NL PT SE**

(30) Priorität: **19.02.1997   DE 19706516**

(43) Veröffentlichungstag der Anmeldung:
**08.12.1999   Patentblatt 1999/49**

(73) Patentinhaber: **FRAUNHOFER-GESELLSCHAFT ZUR FÖRDERUNG DER ANGEWANDTEN FORSCHUNG E.V.**
**80636 München (DE)**

(72) Erfinder:
• **GRILL, Bernhard**
  **D-91207 Lauf (DE)**
• **EDLER, Bernd**
  **D-30419 Hannover (DE)**
• **BRANDENBURG, Karlheinz**
  **D-91054 Erlangen (DE)**

(74) Vertreter: **Schoppe, Fritz, Dipl.-Ing.**
**Schoppe, Zimmermann & Stöckeler**
**Patentanwälte**
**Postfach 71 08 67**
**81458 München (DE)**

(56) Entgegenhaltungen:
**EP-A- 0 578 436        EP-A- 0 770 990**
**EP-A- 0 805 435**

**Beschreibung**

Die vorliegende Erfindung bezieht sich auf Verfahren und Vorrichtungen zum Codieren von diskreten Signalen bzw. zum Decodieren von codierten diskreten Signalen und insbesondere auf eine effiziente Implementierung einer Differenzcodierung für skalierbare Audiocodierer.

Skalierbare Audiocodierer sind Codierer, die modular aufgebaut sind. So besteht die Bestrebung, bereits bestehende Sprachcodierer zu verwenden, die Signale, die z. B. mit 8 kHz abgetastet sind, verarbeiten können und Datenraten von beispielsweise 4,8 bis 8 Kilobit pro Sekunde ausgeben können. Diese bekannten Codierer, wie z. B. die für Fachleute bekannten Codierer G. 729, G.723, FS1016 und CELP, dienen hauptsächlich zum Codieren von Sprachsignalen und sind im allgemeinen zum Codieren von höherqualitativen Musiksignalen nicht geeignet, da sie üblicherweise für mit 8 kHz abgetastete Signale entworfen sind, weshalb sie lediglich eine Audiobandbreite von maximal 4 kHz codieren können. Sie zeigen jedoch im allgemeinen einen schnellen Betrieb und einen geringen Rechenaufwand.

Zur Audiocodierung von Musiksignalen, um beispielsweise HIFI-Qualität oder CD-Qualität zu erreichen, wird daher bei einem skalierbaren Codierer ein Sprachcodierer mit einem Audiocodierer kombiniert, der Signale mit höherer Abtastrate, wie z. B. 48 kHz, codieren kann. Selbstverständlich ist es auch möglich, den oben genannten Sprachcodierer durch einen anderen Codierer zu ersetzen, beispielsweise durch einen Musik/Audiocodierer nach den Standards MPEG1, MPEG2 oder MPEG3.

Eine derartige Kettenschaltung eines Sprachcodierers mit einem höherwertigen Audiocodierer verwendet üblicherweise das Verfahren der Differenzcodierung im Zeitbereich. Ein Eingangssignal, das beispielsweise eine Abtastrate von 48 kHz aufweist, wird mittels eines Downsampling-Filters auf die für den Sprachcodierer geeignete Abtastfrequenz herunter-abgetastet. Nun wird das herunter-abgetastete Signal codiert. Das codierte Signal kann direkt einer Bitstromformatiereinrichtung zugeführt werden, um übertragen zu werden. Es enthält jedoch lediglich Signale mit einer Bandbreite von z. B. maximal 4 kHz. Das codierte Signal wird ferner wieder decodiert und mittels eines Upsampling-Filters herauf-abgetastet. Das nun erhaltene Signal besitzt jedoch aufgrund des Downsampling-Filters lediglich Nutzinformationen mit einer Bandbreite von beispielsweise 4 kHz. Ferner ist festzustellen, daß der Spektralgehalt des herauf-abgetasteten codierten/decodierten Signals im unteren Band bis 4 kHz nicht exakt dem ersten 4-kHz-Band des mit 48 kHz abgetasteten Eingangssignals entspricht, da Codierer im allgemeinen Codierfehler einführen (siehe "First Ideas on Scalable Audio Coding", K. Brandenburg, B. Grill, 97th AES-Convention, San Francisco, 1994, Preprint 3924).

Wie bereits erwähnt wurde, weist ein skalierbarer Codierer sowohl einen allgemein bekannten Sprachcodierer als auch einen Audiocodierer auf, der Signale mit höheren Abtastraten verarbeiten kann. Um Signalanteile des Eingangssignals übertragen zu können, deren Frequenzen über 4 kHz sind, wird eine Differenz des Eingangssignals mit 8 kHz und des codierten/decodierten, herauf-abgetasteten Ausgangssignals des Sprachcodierers für jeden einzelnen zeitdiskreten Abtastwert gebildet. Diese Differenz kann dann mittels eines bekannten Audiocodierers quantisiert und codiert werden, wie es für Fachleute bekannt ist. An dieser Stelle sei angemerkt, daß das Differenzsignal, das in den Audiocodierer, der Signale mit höheren Abtastraten codieren kann, eingespeist wird, im unteren Frequenzbereich abgesehen von Codierfehlern des Sprachcodierers im wesentlichen Null ist. In dem Spektralbereich, der oberhalb der Bandbreite des herauf-abgetasteten codierten/decodierten Ausgangssignals des Sprachcodierers liegt, entspricht das Differenzsignal im wesentlichen dem wahren Eingangssignal bei 48 kHz.

In der ersten Stufe, d.h. der Stufe des Sprachcodierers, wird also zumeist ein Codierer mit niedriger Abtastfrequenz eingesetzt, da im allgemeinen eine sehr niedrige Bitrate des codierten Signals angestrebt wird. Derzeit arbeiten mehrere Codierer, auch die genannten Codierer, mit Bitraten von wenigen Kilobit (zwei bis 8 Kilobit oder auch darüber). Dieselben ermöglichen ferner eine maximale Abtastfrequenz von 8 kHz, da ohnehin nicht mehr Audiobandbreite bei dieser geringen Bitrate möglich ist, und die Codierung bei niedriger Abtastfrequenz bezüglich des Rechenaufwands günstiger ist. Die maximal mögliche Audiobandbreite beträgt 4 kHz und ist in der Praxis auf etwa 3,5 kHz beschränkt. Soll jetzt in der weiteren Stufe, d.h. in der Stufe mit dem Audiocodierer, eine Bandbreitenverbesserung erzielt werden, muß diese weitere Stufe mit einer höheren Abtastfrequenz arbeiten.

Zur Anpassung der Abtastfrequenzen werden Dezimations- und Interpolationsfilter zum Down- bzw. Upsampling eingesetzt. Da zur Erzielung eines günstigen Phasenverhaltens im allgemeinen FIR-Filter (FIR = Finite Impulse Response = begrenzte Impulsantwort) eingesetzt werden, können z. B. bei der Anpassung von 8 kHz auf 48 kHz Filterordnungen von einigen hundert Koeffizienten oder "Taps" erforderlich sein.

Ausgehend von diesem Stand der Technik besteht die Aufgabe der vorliegenden Erfindung darin, Verfahren und Vorrichtungen zum Codieren von diskreten Signalen bzw. zum Decodieren von codierten diskreten Signalen zu schaffen, die ohne aufwendige Upsampling-Filter arbeiten können.

Diese Aufgabe wird durch ein Verfahren zum Codieren gemäß Anspruch 1, durch ein Verfahren zum Decodieren gemäß Anspruch 13, durch eine Vorrichtung zum Codieren gemäß Anspruch 14 und durch eine Vorrichtung zum Decodieren gemäß Anspruch 15 gelöst.

Ein Vorteil der vorliegenden Erfindung besteht darin, daß bei der erfindungsgemäßen Vorrichtung zum Codieren (skalierbarer Audiocodierer), die wenigstens zwei separate Codierer aufweist, ein zweiter Codierer unter Berücksichtigung des psychoakustischen Modells optimal arbeiten kann.

Der Erfindung liegt die Erkenntnis zugrunde, daß auf das rechenzeitaufwendige Upsampling-Filter verzichtet werden kann, wenn ein Audiocodierer bzw. Decodierer verwendet wird, der im Spektralbereich codiert bzw. decodiert, und wenn die Differenzbildung bzw. inverse Differenzbildung zwischen dem codierten/decodierten Ausgangssignal des Codierers bzw. Decodierers niedrigerer Ordnung und dem ursprünglichen Eingangssignal bzw. der Spektraldarstellung eines auf demselben basierenden Signals mit hoher Abtastfrequenz im Frequenzbereich durchgeführt wird. Es ist somit nicht mehr notwendig, das codierte/decodierte Ausgangssignal des Codierers niedrigerer Ordnung mittels eines herkömmlichen Upsampling-Filters herauf-abzutasten, sondern es werden lediglich zwei Filterbänke benötigt, und zwar eine Filterbank für eben das codierte/decodierte Ausgangssignal des Codierers niedrigerer Ordnung und eine Filterbank für das ursprüngliche Eingangssignal mit hoher Abtastfrequenz.

Beide genannten Filterbänke liefern als Ausgangssignale Spektralwerte, die mittels einer geeigneten Bewertungseinrichtung, die bevorzugterweise als Subtrahiereinrichtung ausgeführt ist, bewertet werden, um bewertete Spektralwerte zu bilden. Diese bewerteten Spektralwerte können dann mittels eines Quantisierers und Codierers unter Berücksichtigung eines psychoakustischen Modells codiert werden. Die Daten, die aus der Quantisierung und Codierung der bewerteten Spektralwerte entstanden sind, können bevorzugterweise zusammen mit den codierten Signalen des Codierers niedrigerer Ordnung in eine Bitformatiereinrichtung eingespeist werden, um geeignet gemultiplext zu werden, um übertragen oder gespeichert werden zu können.

An dieser Stelle sei angemerkt, daß die Rechenzeitersparnis in der Tat immens ist. Bei dem genannten Beispiel, bei dem der Sprachcodierer mit 8 kHz abgetastete Signale verarbeitet, und ferner mit 48 kHz abgetastete Signale codiert werden sollen, wird ein Upsamling-FIR-Filter über 100 Multiplikationen pro Abtastwert oder Sample benötigen, während eine Filterbank, die mittels einer für Fachleute bekannten MDCT implementiert sein kann, lediglich etwa zehn bis zu mehreren zehn (z. B. etwa 30) Multiplikationen pro Abtastwert erfordert.

An dieser Stelle sei darauf hingewiesen, daß bei einem skalierbaren Audiocodierer gemäß der vorliegenden Erfindung der Sprachcodierer auch durch einen beliebigen Codierer gemäß den Standards MPEG1 bis MPEG3 ersetzt werden kann, solange die beiden Codierer in der ersten und in der zweiten Stufe für zwei unterschiedliche Abtastfrequenzen ausgelegt sind.

Bevorzugte Ausführungsbeispiele der vorliegenden Erfindung werden nachfolgend bezugnehmend auf die beiliegenden Zeichnungen detaillierter erläutert. Es zeigen:

Fig. 1 ein Blockschaltbild einer Vorrichtung zum Codieren gemäß der vorliegenden Erfindung;

Fig. 2 ein Blockschaltbild einer Vorrichtung zum Decodieren für codierte diskrete Zeitsignale; und

Fig. 3 ein detailliertes Blockschaltbild eines Quantisierers/Codierers von Fig.1.

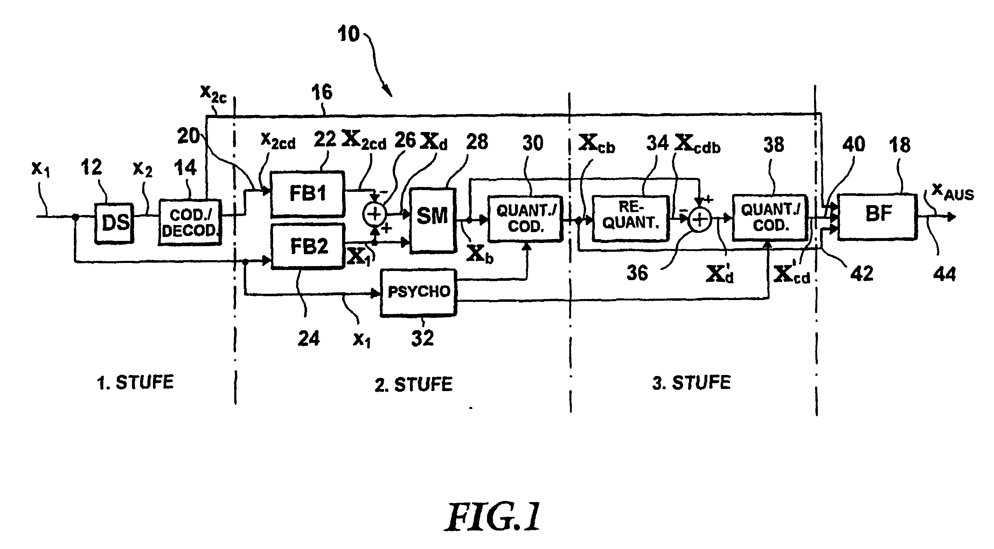

Fig. 1 zeigt ein Prinzipblockschaltbild einer Vorrichtung zum Codieren eines zeitdiskreten Signals (eines skalierbaren Audiocodierers) gemäß der vorliegenden Erfindung. Ein mit einer ersten Abtastrate, z. B. 48 kHz, abgetastetes diskretes Zeitsignal $x_1$ wird mittels eines Downsampling-Filters 12 auf eine zweite Abtastrate, z. B. 8 kHz, gebracht, wobei die zweite Abtastrate kleiner als die erste Abtastrate ist. Vorzugsweise bilden die erste und die zweite Abtastrate ein ganzzahliges Verhältnis. Das Ausgangssignal des Downsampling-Filters 12, das als ein Dezimationsfilter implementiert sein kann, wird in einen Codierer/Decodierer 14 eingegeben, der sein Eingangssignal gemäß einem ersten Codieralgorithmus codiert. Der Codierer/Decodierer 14 kann, wie es bereits erwähnt wurde, ein Sprachcodierer niedrigerer Ordnung sein, wie z. B. ein Codierer G.729, G. 723, FS1016, MPEG-4 CELP, usw. Solche Codierer arbeiten bei Datenraten von 4,8 Kilobit pro Sekunde (FS1016) bis zu Datenraten bei 8 Kilobit pro Sekunde (G.729). Alle verarbeiten Signale, die mit einer Abtastfrequenz von 8 kHz abgetastet worden sind. Für Fachleute ist es jedoch offensichtlich, daß beliebige andere Codierer mit anderen Datenraten bzw. anderen Abtastfrequenzen eingesetzt werden könnten.

Das von dem Codierer 14 codierte Signal, d.h. das codierte zweite Signal $x_{2c}$, das ein von dem Codierer 14 abhängiger Bitstrom ist und bei einer der genannten Bitraten vorliegt, wird über eine Leitung 16 in eine Bitformatiereinrichtung 18 eingegeben, wobei die Funktion der Bitformatiereinrichtung 18 später beschrieben wird. Das Downsampling-Filter 12 sowie der Codierer/Decodierer 14 bilden eine erste Stufe des skalierbaren Audiocodierers gemäß der vorliegenden Erfindung.

Die auf der Leitung 16 ausgegebenen codierten zweiten Zeitsignale $x_{2c}$ werden ferner in dem ersten Codierer/Decodierer 14 wieder decodiert, um codierte/decodierte zweite Zeitsignale $x_{2cd}$ auf einer Leitung 20 zu erzeugen. Die codierten/decodierten zweiten Zeitsignale $x_{2cd}$ sind zeitdiskrete Signale, die eine im Vergleich zu den ersten diskreten Zeitsignalen $x_1$ reduzierte Bandbreite aufweisen. Bei dem genannten Zahlenbeispiel weist das erste diskrete Zeitsignal $x_1$ eine Bandbreite von maximal 24 kHz auf, da die Abtastfrequenz 48 kHz ist. Die codierten/decodierten zweiten Zeitsignale $x_{2cd}$ weisen eine Bandbreite von maximal 4 kHz auf, da das Downsampling-Filter 12 das erste Zeitsignal $x_1$ mittels Dezimation auf eine Abtastfrequenz von 8 kHz umgesetzt hat. Innerhalb der Bandbreite von null bis 4 kHz sind die Signale $x_1$ und $x_{cd}$ abgesehen von durch den Codierer/Decodierer 14 eingeführten Codierungsfehlern gleich.

Hier sei angemerkt, daß die durch den Codierer 14 eingeführten Codierungsfehler nicht immer kleine Fehler sind, sondern daß dieselben ohne weiteres in Größenordnungen des Nutzsignals kommen können, wenn beispielsweise ein stark transientes Signal im ersten Codierer codiert wird. Aus diesem Grund wird überprüft, ob eine Differenzcodierung überhaupt sinnvoll ist, wie es weiter unten erklärt ist.

Die Signale $x_{2cd}$ sowie die Signale $x_1$ werden jeweils in eine Filterbank FB1 22 bzw. in eine Filterbank FB2 24 eingespeist. Die Filterbank FB1 22 erzeugt Spektralwerte $X_{2cd}$, die eine Frequenzbereichsdarstellung der Signale $x_{cd}$ sind. Die Filterbank FB2 hingegen erzeugt Spektralwerte $X_1$, die eine Frequenzbereichsdarstellung des ursprünglichen ersten Zeitsignals $x_1$ sind. Die Ausgangssignale der beiden Filterbänke werden in einer Summationseinrichtung 26 subtrahiert. Genauer gesagt werden die Ausgangsspektralwerte $X_{2cd}$ der Filterbank FB1 22 von den Ausgangsspektralwerten der Filterbank FB2 24 subtrahiert. Der Summationseinrichtung 26 nachgeschaltet ist ein Schaltmodul SM 28, das als Eingangssignal sowohl das Ausgangssignal $X_d$ der Summationseinrichtung 26 als auch das Ausgangssignal $X_1$ der Filterbank 224, d.h. die Spektraldarstellung der ersten Zeitsignale, welche nachfolgend als erste Spektralwerte $X_2$ bezeichnet werden, erhält.

Das Schaltmodul 28 speist eine Quantisierungs/Codierungseinrichtung 30, die eine für Fachleute bekannte Quantisierung unter Berücksichtigung eines psychoakustischen Modells durchführt, das durch ein psychoakustisches Modul 32 symbolisiert ist. Die beiden Filterbänke 22, 24, die Summationseinrichtung 26, das Schaltmodul 28, der Quantisierer/Codierer 30 und das psychoakustische Modul 32 bilden eine zweite Stufe des skalierbaren Audiocodierers gemäß der vorliegenden Erfindung.

Eine dritte Stufe des skalierbaren Audiocodierers der vorliegenden Erfindung umfaßt einen Requantisierer 34, der die durch den Quantisierer/Codierer 30 durchgeführte Verarbeitung wieder rückgängig macht. Das Ausgangssignal Xcdb des Requantisierers 34 wird in eine weitere Summationseinrichtung 36 mit negativem Vorzeichen eingespeist, während das Ausgangssignal $X_b$ des Schaltmoduls 28 in die weitere Summationseinrichtung 36 mit positivem Vorzeichen eingespeist wird. Das Ausgangssignal $X'_d$ der weiteren Summationseinrichtung 36 wird mittels eines weiteren Quantisierers/Codierers 38 unter Berücksichtigung des psychoakustischen Modells, das im psychoakustischen Modul 32 vorhanden ist, quantisiert und codiert, um auf einer Leitung 40 ebenfalls die Bitformatierungseinrichtung 18 zu erreichen. Die Bitformatierungseinrichtung 18 empfängt ferner das Ausgangssignal $X_{cb}$ des ersten Quantisierers/Codierers 30. Das Ausgangssignal $x_{AUS}$ der Bitformatierungseinrichtung 18, das auf einer Leitung 44 vorhanden ist, umfaßt, wie es aus Fig. 1 ersichtlich ist, das codierte zweite zeitsignal $x_{2c}$, das Ausgangssignal des ersten Quantisierers/Codierers 30 $X_{cb}$, sowie das Ausgangssignal $X'_{cd}$ des weiteren Quantisierers/Codierers 38.

Im nachfolgenden wird der Betrieb des skalierbaren Audiocodierers gemäß Fig. 1 erklärt. Die diskreten, mit einer ersten Abtastrate abgetasteten ersten Zeitsignale $x_1$ werden, wie es bereits erwähnt wurde, in das Downsampling-Filter 12 eingespeist, um zweite Zeitsignale $x_2$ zu erzeugen, deren Bandbreite einer zweiten Abtastrate entspricht, wobei die zweite Abtastrate kleiner als die erste Abtastrate ist. Der Codierer/Decodierer 14 erzeugt aus dem zweiten Zeitsignalen $x_2$ gemäß eines ersten Codieralgorithmus zweite codierte Zeitsignale $x_{2c}$ sowie mittels einer anschließenden Decodierung gemäß dem ersten Codierungsalgorithmus codierte/decodierte zweite Zeitsignale $x_{2cd}$. Die codierten/decodierten zweiten Zeitsignale $x_{2cd}$ werden mittels der ersten Filterbank FB1 22 in den Frequenzbereich transformiert, um zweite Spektralwerte $X_{2cd}$ zu erzeugen, die eine Frequenzbereichsdarstellung der codierten/decodierten zweiten Zeitsignale $x_{2cd}$ sind.

An dieser Stelle sei angemerkt, daß die codierten/decodierten zweiten Zeitsignale $x_{2cd}$ Zeitsignale mit der zweiten Abtastfrequenz, d.h. 8 kHz beim Beispiel, sind. Die Frequenzbereichsdarstellung dieser Signale und die ersten Spektralwerte $X_1$ sollen nun bewertet werden, wobei die ersten Spektralwerte $X_1$ mittels der zweiten Filterbank FB2 24 aus dem ersten Zeitsignal $x_1$, das die erste, d. h. hohe, Abtastfrequenz aufweist, erzeugt werden. Um vergleichbare Signale zu erhalten, die eine identische Zeit- und Frequenzauflösung haben, muß das 8-kHz-Signal, d.h. das Signal mit der zweiten Abtastfrequenz, auf ein Signal mit der ersten Abtastfrequenz überführt werden.

Dies kann dadurch geschehen, daß zwischen die einzelnen zeitdiskreten Abtastwerte des Signals $x_{2cd}$ eine bestimmte Anzahl von Nullwerten eingefügt wird. Die Anzahl der Nullwerte errechnet sich aus dem Verhältnis der ersten und der zweiten Abtastfrequenz. Das Verhältnis der ersten (hohen) zur zweiten (niedrigen) Abtastfrequenz wird als Upsampling-Faktor bezeichnet. Wie es Fachleuten bekannt ist, wird durch das Einfügen von Nullen, das mit sehr geringem Rechenaufwand möglich ist, eine Aliasing-Störung in dem Signal $x_{2cd}$ erzeugt, die sich derart auswirkt, daß das niederfrequente oder Nutzspektrum des Signals $x_{2cd}$ wiederholt wird, und zwar insgesamt so oft, wie viel Nullen eingefügt werden. Das Aliasing-behaftete Signal $x_{2cd}$ wird nun mittels der ersten Filterbank FB1 in den Frequenzbereich transformiert, um zweite Spektralwerte $X_{2cd}$ zu erzeugen.

Durch das Einfügen von z.B. fünf Nullen zwischen jeden Abtastwert des codierten/decodierten zweiten Signals $x_{2cd}$ entsteht ein Signal, von dem von vorneherein bekannt ist, daß lediglich jeder sechste Abtastwert dieses Signals von Null verschieden ist. Diese Tatsache kann beim Transformieren dieses Signals in den Frequenzbereich mittels einer Filterbank oder MDCT oder mittels einer beliebigen Fourier-Transformation ausgenützt werden, da beispielsweise auf bestimmte Summationen, die bei einer einfachen FFT auftreten, verzichtet werden kann. Die von vorneherein bekannnte Struktur des zu transformierenden Signals kann somit auf vorteilhafte Weise zur Rechenzeiteinsparung bei einer Transformation desselben in den Frequenzbereich verwendet werden.

Die zweiten Spektralwerte $X_{2cd}$ sind nur im unteren Teil eine korrekte Darstellung des codierten/decodierten zweiten Zeitsignals $x_{2cd}$, weshalb am Ausgang der Filterbank FB1 nur maximal das 1/Upsampling-Faktor-fache der gesamten Spektrallinien $X_{2cd}$ verwendet wird. An dieser Stelle sei angemerkt, daß die verwendete Anzahl der Spektrallinien $X_{2cd}$ durch das Einfügen der Nullen in dem codierten/decodierten zweiten Zeitsignal $x_{2cd}$ nun dieselbe Zeit- und Frequenzauflösung besitzt, wie die ersten Spektralwerte $X_1$, die eine Frequenzdarstellung ohne Aliasing-Störung des ersten Zeitsignals $x_1$ ist. In der Subtrahiereinrichtung 26 sowie in dem Schaltmodul 28 werden die beiden Signale $X_{2cd}$ und $X_1$ bewertet, um bewertete Spektralwerte $X_b$ oder $X_1$ zu erzeugen. Das Schaltmodul 28 führt nun eine sogenannte Simulcast-Differenz-Umschaltung durch.

Nicht immer ist es günstig, eine Differenzcodierung in der zweiten Stufe zu verwenden. Dies ist beispielsweise dann der Fall, wenn das Differenzsignal, d. h. das Ausgangssignal der Summationseinrichtung 26, eine höhere Energie als das Ausgangssignal der zweiten Filterbank $X_1$ aufweist. Da ferner für den Codierer/Decodierer 14 der ersten Stufe ein beliebiger Codierer verwendet werden kann, kann es vorkommen, daß der Codierer bestimmte in der zweiten Stufe schwer zu codierende Signalanteile produziert. Der Codierer/Decodierer 14 soll vorzugsweise Phaseninformationen des von ihm codierten Signals bewahren, was in der Fachwelt als "Wave-Form-Coding" oder "Signalformcodieren" bezeichnet wird. Die Entscheidung in dem Schaltmodul 28 der zweiten Stufe, ob eine Differenzcodierung oder eine Simulcast-Codierung verwendet wird, wird frequenzabhängig getroffen.

"Differenzcodierung" bedeutet, daß lediglich die Differenz der zweiten Spektralwerte $X_{2cd}$ und der ersten Spektralwerte $X_1$ codiert wird. Falls diese Differenzcodierung jedoch nicht günstig ist, da der Energieinhalt des Differenzsignals größer als der Energieinhalt der ersten Spektralwerte $X_1$ ist, dann wird von einer Differenzcodierung abgesehen. Wird von einer Differenzcodierung abgesehen, dann werden die ersten Spektralwerte $X_1$ des im Beispiel mit 48 kHz abgetasteten Zeitsignals $x_1$ vom Schaltmodul 28 durchgeschaltet und als Ausganssignal des Schaltmoduls SM 28 verwendet.

Da die Differenzbildung im Frequenzbereich stattfindet, ist es ohne weiteres möglich, eine frequenzselektive Auswahl von Simulcast- oder Differenzcodierung durchzuführen, da die Differenz der beiden Signale $X_1$ und $X_{2cd}$ ohnehin berechnet wird. Die Differenzbildung im Spektrum erlaubt somit eine einfache frequenzselektive Wahl der Frequenzbereiche, welche differenzcodiert werden sollen. Prinzipiell könnte eine Umschaltung von einer Differenz- zu einer Simulcast-Codierung für jeden Spektralwert einzeln auftreten. Dies wird jedoch eine zu große Menge an Seiteninformationen erfordern und nicht unbedingt nötig sein. Daher wird es bevorzugt, beispielsweise ein frequenzgruppenweises Vergleichen der Energien der Differenzspektralwerte und der ersten Spektralwerte durchzuführen. Alternativ dazu können bestimmte Frequenzbänder von vornherein festgelegt werden, z. B. acht Bänder von jeweils 500 Hz Breite, wodurch sich wieder die Bandbreite des Signals $X_{2cd}$ ergibt, wenn das Zeitsignal $x_2$ eine Bandbreite von 4 kHz aufweist. Ein Kompromiß bei der Festlegung der Frequenzbänder besteht darin, die Menge der zu übertragenden Seiteninformationen, d. h. ob in einem Frequenzband die Differenzcodierung aktiv ist oder nicht, gegenüber dem Nutzen abzuwägen, der aus einer möglichst häufigen Differenzcodierung erwächst.

Im Bitstrom können Seiteninformationen, beispielsweise 8 Bit für jedes Band, ein Ein/Aus-Bit für die Differenzcodierung oder auch eine andere geeignete Codierung übertragen werden, die anzeigen, ob ein bestimmtes Frequenzband differenzcodiert ist oder nicht. Im Decodierer, welcher später beschrieben wird, werden dann dementsprechend bei der Rekonstruktion nur die entsprechenden Teilbänder des ersten Codierers addiert.

Ein Schritt des Bewertens der ersten Spektralwerte $X_1$ und der zweiten Spektralwerte $X_{2cd}$ umfaßt somit vorzugsweise das Subtrahieren der zweiten Spektralwerte $X_{2cd}$ von den ersten Spektralwerten $X_1$, um Differenzspektralwerte $X_d$ zu erhalten. Zudem werden dann auf bekannte Art und Weise, beispielsweise durch Summieren und Quadrieren, die Energien mehrerer Spektralwerte in einem vorbestimmten Band, beispielsweise 500 Hz beim 8-kHz-Beispiel, für die Differenz-Spektralwerte $X_d$ sowie für die ersten Spektralwerte $X_1$ berechnet. In jedem Frequenzband wird nun ein frequenzselektives Vergleichen der jeweiligen Energien durchgeführt. Falls die Energie in einem bestimmten Frequenzband der Differenzspektralwerte $X_d$ die Energie der ersten Spektralwerte $X_1$ multipliziert mit einem vorbestimmten Faktor k überschreitet, wird bestimmt, daß die bewerteten Spektralwerte $X_b$ die ersten Spektralwerte $X_1$ sind. Andernfalls wird bestimmt, daß die Differenz-Spektralwerte $X_d$ die bewerteten Spektralwerte $X_1$ sind. Der Faktor k kann beispielsweise etwa von 0,1 bis 10 reichen. Bei Werten von k kleiner 1 wird bereits eine Simulcast-Codierung eingesetzt, wenn das Differenzsignal eine geringere Energie als das Ursprungssignal aufweist. Bei Werten von k größer 1 wird dagegen weiter eine Differenzcodierung verwendet, selbst wenn der Energieinhalt des Differenzsignals bereits größer als der des nicht im ersten Codierer codierten Ursprungssignals ist. Wird eine Simulcast-Codierung bewertet, wird das Schaltmodul 28 die Ausgangssignale der zweiten Filterbank 24 gewissermaßen direkt durchschalten. Als Alternative zu der beschriebenen Differenzbildung kann auch eine Bewertung derart durchgeführt werden, daß z. B. ein Verhältnis oder eine Multiplikation oder eine sonstige Verknüpfung der beiden genannten Signale durchgeführt wird.

Die bewerteten Spektralwerte $X_b$, die entweder die Differenz-spektralwerte $X_d$ oder die ersten Spektralwerte $X_1$ sind, wie es durch das Schaltmodul 28 bestimmt wurde, werden nun mittels eines ersten Quantisierers/Codierers 30 unter Berücksichtigung des psychoakustischen Models, das für Fachleute bekannt ist und in dem psychoakustischen Modell 32 vorhanden ist, quantisiert und anschließend vorzugsweise mittels einer Redundanz-reduzierenden Codierung, beispielsweise unter Verwendung von Huffman-Tabellen, codiert. Wie es für Fachleute ferner bekannt ist, wird das psychoakustische Modell aus Zeitsignalen berechnet, weshalb das erst Zeitsignal $x_1$ mit der hohen Abtastrate direkt in das psychoakustische Modul 32 eingespeist wird, wie es in Fig. 1 zu sehen ist. Das Ausgangssignal $X_{cb}$ des Quantisierers/Codierers 30 wird auf der Leitung 42 direkt zur Bitformatiereinrichtung 18 geleitet und ins Ausgangssignal $x_{AUS}$ geschrieben.

Im Vorhergehenden wurde ein skalierbarer Audiocodierer mit einer ersten und einer zweiten Stufe beschrieben. Gemäß einem vorteilhaften Aspekt der Erfindung ist das erfindungsgemäße Konzept des skalierbaren Audiocodierers in der Lage, auch mehr als zwei Stufen zu kaskadieren. So wäre es beispielsweise möglich, bei einem Eingangssignal $x_1$, das mit 48 kHz abgetastet ist, im ersten Codierer/Decodierer 14 mittels Reduzierung der Abtastrate die ersten 4 kHz des Spektrums zu codieren, um eine Signalqualität nach der Decodierng zu erreichen die etwa der Sprachqualität von Telefongesprächen entspricht. In der zweiten Stufe könnte, implementiert durch den Quantisierer/Codierer 30, eine Bandbreitencodierung von bis zu 12 kHz durchgeführt werden, um eine Tonqualität zu erreichen, die etwa der HIFI-Qualität entspricht. Für Fachleute ist es offensichtlich, daß ein mit 48 kHz abgetastetes Signal $x_1$ eine Bandbreite von 24 kHz haben kann. Die dritte Stufe könnte nun implementiert durch den weiteren Quantisierer/Codierer 38 eine Codierung bis zu einer Bandbreite von maximal 24 kHz oder bei einem praktischen Beispiel von z. B. 20 kHz durchführen, um eine Tonqualität zu erreichen, die etwa der einer Compact Disc (CD) entspricht.

Beim Implementieren der dritten stufe werden die bewerteten Signale $X_b$ am Ausgang des Schaltmoduls 28 zu der weiteren Summationseinrichtung 36 gespeist. Ferner werden die codierten bewerteten Spektralwerte $X_{cb}$, die nun im Beispiel eine Bandbreite von 12 kHz aufweisen, in der Requantisierungseinrichtung 34 wieder decodiert, um codierte/decodierte bewertete Spektralwerte $X_{cdb}$ zu erhalten, die ebenfalls im Beispiel eine Bandbreite von 12 kHz haben werden. Durch Differenzbildung in der zweiten Summationseinrichtung 36 werden weitere Differenz-Spektralwerte $X'_d$ berechnet. Die weiteren Differenz-Spektralwerte $X'_d$ können dann im Bereich von 4 kHz bis 12 kHz den Codierungsfehler des Quantisierer/Codierers 30 sowie den vollen Spektralgehalt im Bereich zwischen 12 und 20 kHz enthalten, wenn das verwendete Beispiel weitergeführt wird. Die weiteren Differenz-Spektralwerte $X'_d$ werden nun in dem weiteren Quantisierer/Codierer 38 der dritten Stufe, der im wesentlichen wie der Quantisierer/Codierer 30 der zweiten Stufe ausgeführt sein wird und ebenfalls mittels des psychoakustischen Models gesteuert wird, quantisiert und codiert, um weitere codierte Differenz-Spektralwerte $X'_{cd}$ zu erhalten, die ebenfalls in dem Bitformatierer 18 eingespeist werden können. Der codierten Datenstrom $x_{AUS}$ setzt sich nun neben den ebenfalls zu übertragenden Seiteninformationen aus folgenden Signalen zusammen:

- den codierten zweiten Signalen $x_{2c}$ (volles Spektrum von 0 bis 4 kHz) ;

- den codierten bewerteten Spektralwerten $X_{cb}$ (volles Spektrum von 0 bis 12 kHz bei einer Simulcast-Codierung oder Codierfehler von 0 bis 4 kHz des Codierers 14 und volles Spektrum von 4 bis 12 kHz bei einer Differenzcodierung) ;

- den weiteren codierten Differenzwerten $X'_{cd}$ (Codierfehler von 0 bis 12 kHz des Codierers/Decodierers 14 und des Quantisierers/Codierers 30 und voller Spektralgehalt von 12 bis 20 kHz oder Codierungsfehler des Quantisierers/Codierers 30 von 0 bis 12 kHz bei Simulcast-Betrieb und volles Spektrum von 12 bis 20 kHz).

Eventuell können beim Übergang vom ersten Codierer/Decodierer 14 zum Quantisierer/Codierer 30 im Beispiel beim Übergang von 4 kHz auf einen größeren Wert von 4 kHz Übergangsstörungen auftreten. Diese Übergangsstörungen können sich in fehlerhaften Spektralwerten äußern, die in den Bitstrom $x_{AUS}$ geschrieben werden. Der Gesamtcodierer/Decodierer kann nun so spezifiziert werden, daß z. B. nur die Frequenzlinien bis 1/Upsampling-Faktor minus x (x = 1, 2, 3) verwendet werden. Dies führt dazu, daß die letzten Spektrallinien des Signals $X_{2cd}$ am Ende der gemäß der zweiten Abtastfrequenz erreichbaren maximalen Bandbreite nicht berücksichtigt werden. Implizit wird also eine Bewertungsfunktion verwendet, die beim genannten Fall eine Rechteckfunktion ist, die über einem bestimmten Frequenzwert Null ist und darunter einen Wert von Eins aufweist. Alternativ dazu kann auch eine "weichere" Bewertungsfunktion eingesetzt werden, die Spektrallinien, die Übergangsstörungen haben, in ihrer Amplitude reduziert, wonach die in ihrer Amplitude reduzierten Spektrallinien doch berücksichtigt werden.

An dieser Stelle sei angemerkt, daß die Übergangsstörungen nicht hörbar sind, da sie im Decodierer wieder eliminiert werden. Die Übergangsstörungen können jedoch zu überhöhten Differenzsignalen führen, für die dann der Codierungsgewinn durch die Differenzcodierung verringert wird. Durch Bewerten mit einer Bewertungsfunktion, wie sie oben beschrieben wurde, kann somit ein Verlust an Codierungsgewinn in Grenzen gehalten werden. Eine andere Bewertungsfunktion als die Rechteckfunktion wird keine zusätzlichen Seiteninformationen benötigen, da dieselbe genauso wie die Rechteckfunktion a priori für den Codierer und den Decodierer vereinbart werden kann.

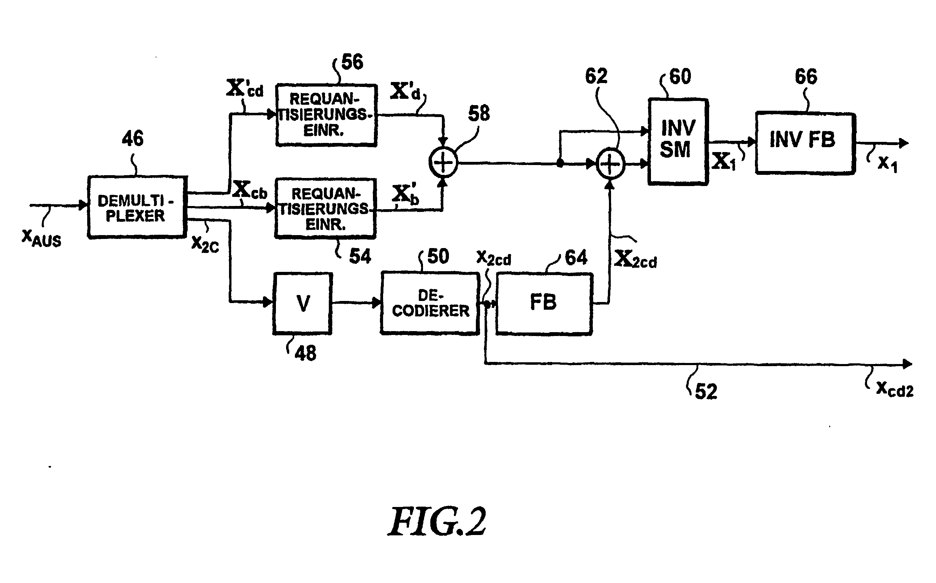

Fig. 2 zeigt ein bevorzugtes Ausführungsbeispiel eines Decodierers zum Decodieren von durch den skalierbaren Audiocodierer gemäß Fig. 1 codierten Daten. Der Ausgangsdatenstrom des Bitformatierers 18 von Fig. 1 wird in einen Demultiplexer 46 eingespeist, um die bezüglich Fig. 1 auf den Leitungen 42, 40 und 16 vorhandenen Signale aus dem Datenstrom $x_{AUS}$ zu gewinnen. Die codierten zweiten Signale $x_{2C}$ werden in ein Verzögerungsglied 48 eingespeist, wobei das Verzögerungsglied 48 eine Verzögerung in die Daten einführt, die aufgrund anderer Gesichtspunkte des Systems notwendig sein kann und keinen Teil der Erfindung darstellt.

Nach der Verzögerung werden die codierten zweiten Signale $x_{2c}$ in einen Decodierer 50 eingespeist, der mittels des ersten Codierungsalgorithmus, der auch in dem Codierer/Decodierer 14 von Fig. 1 implementiert ist, decodiert, um das codierte/decodierte zweite Zeitsignal $x_{cd2}$ zu erzeugen, das über eine Leitung 52 ausgegeben werden kann, wie es in Fig. 2 zu sehen ist. Die codierten bewerteten Spektralwerte $X_{cb}$ werden mittels einer Requantisierungseinrichtung 54, die zu der Requantisierungseinrichtung 34 identisch sein kann, requantisiert, um die bewerteten Spektralwerte $X_b$ zu erhalten. Die weiteren codierten Differenzwerte $X'_{cd}$, die in Fig. 1 auf der Leitung 40 liegen, werden ebenfalls mittels einer Requantisierungseinrichtung 56, die zur Requantisierungseinrichtung 54 und zur Requantisierungseinrichtung 34 (Fig. 1) identisch sein kann, requantisiert, um weitere Differenz-Spektralwerte $X'_d$ zu erhalten. Eine Summationseinrichtung 58 bildet die Summe der Spektralwerte $X_b$ und $X'_d$, welche bereits den Spektralwerten $X_1$ des ersten Zeitsignals $x_1$ entsprechen, wenn eine Simulcast-Codierung verwendet wurde, wie es durch ein inverses Schaltmodul 60 aufgrund von in dem Bitstrom übertragenen Seiteninformationen bestimmt wird.

Wurde eine Differenzcodierung verwendet, so wird das Ausgangssignal der Summationseinrichtung 58 in eine Summationseinrichtung 60 eingespeist, um die Differenzcodierung rückgängig zu machen. Wenn dem inversen Schaltmodul 60 eine Differenzcodierung signalisiert worden ist, so wird das den in Fig. 2 gezeigten oberen Eingangszweig sperren und den unteren Eingangszweig durchschalten, um die ersten Spektralwerte $X_1$ auszugeben.

An dieser Stelle sei angemerkt, daß, wie aus Fig. 2 ersichtlich ist, das codierte/decodierte zweite Zeitsignal mittels einer Filterbank 64 in den Frequenzbereich transformiert werden muß, um die zweiten Spektralwerte $X_{2cd}$ zu erhalten, da die Summation der Summationseinrichtung 62 eine Summation von Spektralwerten ist. Die Filterbank 64 ist vorzugsweise mit den Filterbänken FB1 22 und FB2 24 identisch, wodurch nur eine Einrichtung implementiert werden muß, die bei Verwendung geeigneter Puffer nacheinander mit verschiedenen Signalen gespeist wird. Alternativ können auch geeignete unterschiedliche Filterbänke eingesetzt werden.

Wie es bereits erwähnt wurde, werden aus dem ersten Zeitsignal $x_1$ mittels des psychoakustischen Moduls 32 Informationen abgeleitet, die bei der Quantisierung von Spektralwerten verwendet werden. Insbesondere besteht die Bestrebung, im Sinne einer Minimierung der zu übertragenden Datenmenge, die Spektralwerte möglichst grob zu quantisieren. Andererseits sollen durch die Quantisierung eingeführte Störungen nicht hörbar sein. Ein in dem psychoakustischen Modul 32 vorhandenes an sich bekanntes Modell wird verwendet, um eine erlaubte Störungsenergie zu berechnen, die durch die Quantisierung eingeführt werden kann, damit keine Störung hörbar ist. Eine Steuerung steuert nun in einem bekannten Quantisierer/Codierer den Quantisierer, um eine Quantisierung durchzuführen, die eine Quantisierungsstörung einführt, die kleiner oder gleich der erlaubten Störung ist. Dies wird bei bekannten Systemen ständig überwacht, indem das durch den Quantisierer, der z. B. im Block 30 enthalten ist, quantisierte Signal wieder dequantisiert wird. Durch Vergleich des Eingangssignals in den Quantisierer mit dem quantisierten/dequantisierten Signal wird die tatsächlich durch die Quantisierung eingeführte Störungsenergie berechnet. Die tatsächliche Störungsenergie des quantisierten/dequantisierten Signals wird in der Steuerung mit der erlaubten Störungsenergie verglichen. Ist die tatsächliche Störungsenergie größer als die erlaubte Störungsenergie, so wird die Steuerung in dem Quantisierer eine feinere Quantisierung einstellen. Der Vergleich zwischen erlaubter und tatsächlicher Störungsenergie findet typischerweise pro psychoakustischem Frequenzband statt. Dieses Verfahren ist bekannt und wird von dem skalierbaren Audiocodierer gemäß der vorliegenden Erfindung verwendet, wenn eine Simulcast-Codierung verwendet wird.

Falls eine Differenzcodierung bestimmt worden ist, kann das bekannte Verfahren nicht verwendet werden, da ja keine Spektralwerte sondern Differenzspektralwerte $X_b$ quantisiert werden sollen. Das psychoakustische Modell liefert erlaubte Störenergieen $E_{PM}$ pro psychoakustischem Frequenzband, die für einen Vergleich mit Differenzspektralwerten nicht geeignet sind.

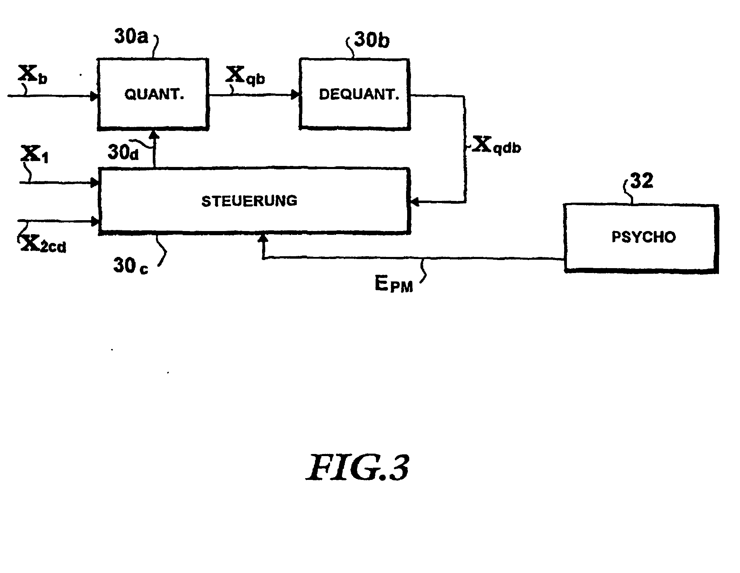

Fig. 3 zeigt ein detailliertes Blockschaltbild des Quantisierers/Codierers 30 oder 38 von Fig. 1. Die bewerteten Spektralwerte $X_b$ gelangen in einen Quantisierer 30a, der quantisierte bewertete Spektralwerte $X_{qb}$ liefert. Die quantisierten bewerteten Spektralwerte werden anschließend in einem Dequantisierer 30b invers quantisiert, um quantisierte/dequantisierte bewertete Spektralwerte $X_{qdb}$ zu ergeben. Dieselben werden in eine Steuerung 30c eingespeist, die von dem psychoakustischen Modul 38 die erlaubte Störungsenergie $E_{PM}$ pro Frequenzband erhält. Zu dem Signal $X_{qdb}$, das ja Differenzen darstellt, wird das Signal $X_{2cd}$ addiert, um ein mit der Ausgabe des psychoakustischen Moduls vergleichbares Signal zu schaffen. In der Steuerung 30c wird die tatsächliche Störenergie ETS für ein Frequenzband mittels folgender Gleichung berechnet wird:

$$E_{TS} = \Sigma(X_1[i] - (X_{qdb} + X_{2cd}))^2$$

Durch einen Vergleich der tatsächlichen Störenergie $E_{TS}$ mit der erlaubten Störenergie $E_{PM}$ stellt die Steuerung fest, ob die Quantisierung zu fein oder zu grob ist, um die Quantisierung für den Quantisierer 30a über eine Leitung 30d derart einzustellen, daß die tatsächliche Störung kleiner als die erlaubte Störung ist. Für Fachleute ist es offensichtlich, daß die Energie eines Spektralwertes berechnet wird, indem derselbe quadriert wird, und daß die Energie eines Frequenzbandes bestimmt wird, indem die quadrierten in dem Frequenzband vorhandenen Spektralwerte addiert werden. Ferner ist es wichtig, darauf hinzuweisen, daß sich die Breite der Frequenzbänder der Differenzcodierung von der Breite der psychoakustischen Frequenzbänder (d. h. Frequenzgruppen) unterscheiden kann, was im allgemeinen auch der Fall ist. Die Frequenzbänder, die bei der Differenzcodierung verwendet werden, werden zum Erreichen einer effizienten Codierung festgelegt, während die psychoakustischen Frequenzbänder oder Frequenzgruppen durch die Wahrnehmung des menschlichen Ohrs, d. h. durch das psychoakustische Modell, festgelegt sind.

Für Fachleute ist offensichtlich, daß das gegebene Beispiel, bei dem die ersten Abtastfrequenz 48 kHz beträgt und die zweite Abtastfrequenz 8 kHz beträgt, lediglich beispielhaft ist. Als zweite niederere Abtastfrequenz kann auch eine kleinere Frequenz als 8 kHz verwendet werden. Als Abtastfrequenzen für das Gesamtsystem können 48 kHz, 44,1 kHz, 32 kHz, 24 kHz, 22,05 kHz, 16 kHz, 8 kHz oder eine andere geeignete Abtastfrequenz verwendet werden. Der Bitratenbereich des Codierers/ Decodierers 14 der ersten Stufe kann, wie es bereits erwähnt wurde, von 4,8 kBit pro Sekunde bis zu 8 kBit pro Sekunde reichen. Der Bitratenbereich des zweiten Codierers in der zweiten Stufe kann von 0 bis 64, 69,659, 96, 128, 192 oder 256 kBit pro Sekunde bei Abtastraten von 48, 44,1, 32, 24, 16 bzw 8 kHz reichen. Der Bitratenbereich des Codierers der dritten Stufen kann von 8 kBit pro Sekunde bis 448 kBit pro Sekunde für alle Abtastraten reichen.

**Patentansprüche**

1. Verfahren zum Codieren von diskreten, mit einer ersten Abtastrate abgetasteten ersten Zeitsignalen ($x_1$), mit folgenden Schritten:

   Erzeugen von zweiten Zeitsignalen ($x_2$), deren Bandbreite einer zweiten Abtastrate entspricht, aus den ersten Zeitsignalen ($x_1$), wobei die zweite Abtastrate kleiner als die erste Abtastrate ist;

   Codieren der zweiten Zeitsignale ($x_2$) gemäß einem ersten Codieralgorithmus, um codierte zweite Signale ($x_{2c}$) zu erhalten;

   Decodieren der codierten zweiten Signale ($x_{2c}$) gemäß dem ersten Codieralgorithmus, um codierte/decodierte zweite Zeitsignale ($x_{2cd}$) zu erhalten, deren Bandbreite der zweiten Abtastfrequenz entspricht;

   Transformieren der ersten Zeitsignale ($x_1$) in den Frequenzbereich, um erste Spektralwerte ($X_1$) zu erhalten;

   Erzeugen von zweiten Spektralwerten ($X_{2cd}$) aus den codierten/decodierten zweiten Zeitsignalen ($x_{2cd}$), wobei die zweiten Spektralwerte ($X_{2cd}$) eine Darstellung der codierten/decodierten zweiten Zeitsignale ($x_{2cd}$) im Frequenzbereich sind und eine zu den ersten Spektralwerten ($X_1$) im wesentlichen gleiche Zeit- und Frequenzauflösung aufweisen;

   Bewerten der ersten Spektralwerte ($X_1$) mit den zweiten Spektralwerten ($X_{2cd}$), um bewertete Spektralwerte ($X_b$) zu erhalten, deren Anzahl der Anzahl der ersten Spektralwerte ($X_1$) entspricht; und

   Codieren der bewerteten Spektralwerten ($X_b$) gemäß einem zweiten Codieralgorithmus, um codierte bewertete Spektralwerte ($X_{cb}$) zu erhalten.

2. Verfahren nach Anspruch 1, bei dem der Schritt des Erzeugens der zweiten Spektralwerte ($X_{2cd}$) folgende Schritte aufweist:

   Einfügen einer Anzahl von Nullwerten zwischen jedem diskreten Wert der codierten/decodierten zweiten Zeitsignale ($x_{2cd}$), wobei die Anzahl von Nullwerten gleich dem Verhältnis der ersten zur zweiten Abtastfrequenz weniger Eins ist, um ein modifiziertes codiertes/decodiertes zweites Signal zu erhalten;

Transformieren des modifizierten, codierten/decodierten zweiten Signals in den Frequenzbereich, um modifizierte Spektralwerte zu erhalten;

Auswählen eines Bereichs der modifizierten Spektralwerte, um die zweiten Spektralwerte ($X_{2cd}$) zu erhalten, wobei sich der Bereich von dem Spektralwert bei der kleinsten Frequenz bis zu dem Spektralwert erstreckt, dessen Frequenzwert im wesentliche gleich dem Wert der Bandbreite des zweiten Zeitsignals ($x_2$) ist.

**3.** Verfahren nach Anspruch 1, bei dem der Schritt des Erzeugens der zweiten Spektralwerte ($X_{2cd}$) folgende Schritte aufweist:

Einfügen einer Anzahl von Nullwerten zwischen jedes codierte/decodierte zweite Zeitsignal ($x_{2cd}$), wobei die Anzahl von Nullwerten gleich dem Verhältnis der ersten zur zweiten Abtastfrequenz weniger Eins ist, um ein modifiziertes codiertes/decodiertes zweites Signal zu erhalten;

Berechnen lediglich eines Bereichs von Spektralwerten aus dem modifizierten codierten/decodierten zweiten Signal, wobei sich der Bereich von dem Spektralwert von der kleinsten Frequenz bis zu dem Spektralwert erstreckt, dessen Frequenz gleich dem Wert der Bandbreite des zweiten Zeitsignals ($x_2$) ist.

**4.** Verfahren nach Anspruch 2 oder 3, bei dem eine kleine Anzahl von Spektrallinien um die Frequenz herum, die dem Wert der Bandbreite des zweiten Zeitsignals ($x_2$) entspricht, nicht ausgewählt oder mittels einer Bewertungsfunktion gewichtet und dann ausgewählt wird.

**5.** Verfahren nach einem der vorhergehenden Ansprüche, bei dem der Schritt des Bewertens folgende Schritte aufweist:

Subtrahieren der zweiten Spektralwerte ($X_{2cd}$) von den ersten Spektralwerten ($X_1$), um Differenz-Spektralwerte ($X_d$) zu erhalten;

Berechnen einer Energie der Differenz-Spektralwerte ($X_d$);

Berechnen einer Energie der ersten Spektralwerte ($X_1$);

frequenzselektives Vergleichen der Energien der Differenzspektralwerte ($X_d$) und der ersten Spektralwerte ($X_1$) ;

falls die Energie der Differenz-Spektralwerte ($X_d$) die Energie der ersten Spektralwerte ($X_1$) multipliziert mit einem Faktor k in einem Frequenzabschnitt überschreitet, wobei der Faktor k zwischen 0,1 und 10 liegt,

Bestimmen der ersten Spektralwerte ($X_1$) als bewertete Spektralwerte;

sonst, Bestimmen der Differenz-Spektralwerte ($X_d$) als bewertete Spektralwerte ($X_b$).

**6.** Verfahren nach Anspruch 5, bei dem das frequenzselektive Vergleichen frequenzgruppenweise durchgeführt wird.

**7.** Verfahren nach einem der vorhergehenden Ansprüche, bei dem das Codieren der bewerteten Spektralwerte ($X_b$) gemäß dem zweiten Codieralgorithmus unter Berücksichtigung eines psychoakustischen Modells durchgeführt wird.

**8.** Verfahren nach Anspruch 7, bei dem das Codieren folgende Schritte aufweist:

Berechnen einer erlaubten Störenergie ($E_{PM}$) in einem Frequenzband unter Berücksichtigung des psychoakustischen Modells aus dem ersten Zeitsignal ($x_1$) ;

Quantisieren der bewerteten Spektralwerte ($X_b$) in dem Frequenzband;

Dequantisieren der quantisierten bewerteten Spektralwerte ($X_{qb}$) in dem Frequenzband;

Berechnen der tatsächlichen Störenergie ($E_{TS}$) in dem Frequenzband mittels folgender Gleichung:

$$E_{TS} = \Sigma(X_1[i] - (X_{qdb} + X_{2cd}))^2,$$

wobei $X_1$ die ersten Spektralwerte, $X_{qdb}$ die quantisierten/dequantisierten bewerteten Spektralwerte, $X_{2cd}$ die zweiten Spektralwerte und i der Summierindex eines Spektralwerts sind, wobei i vom ersten Spektralwert des Frequenzbandes bis zum letzten Spektralwert des Frequenzbandes reicht;

Vergleichen der tatsächlichen Störenergie ($E_{TS}$) mit der erlaubten Störenergie ($E_{PM}$) in dem Frequenzband;

falls die tatsächliche Störenergie ($E_{TS}$) größer als die erlaubte Störenergie ($E_{PM}$) in dem Frequenzband ist, Codieren mit einer feineren Quantisierung in dem Frequenzband; und

sonst, Codieren mit einer gröberen Quantisierung in dem Frequenzband.

9. Verfahren gemäß einem der vorhergehenden Ansprüche,
bei dem das Codieren gemäß dem zweiten Codieralgorithmus eine Huffman-Codierung zur Redundanzreduktion umfaßt.

10. Verfahren nach einem der vorhergehenden Ansprüche, das ferner folgenden Schritt aufweist:
Formatieren der codierten zweiten Signale ($x_{2c}$) und der codierten bewerteten Signale ($X_{cb}$), um einen übertragbaren Datenstrom ($x_{AUS}$) zu erhalten.

11. Verfahren nach einem der Ansprüche 1 bis 8, das nach dem Schritt des Codierens der bewerteten Spektralwerte ($X_b$) folgende Schritte aufweist:

Decodieren der bewerteten codierten Spektralwerte ($X_{cb}$), um codierte/decodierte bewertete Spektralwerte ($X_{cdb}$) zu erhalten;

Subtrahieren der codierten/decodierten bewerteten Spektralwerte ($X_{cdb}$) von den bewerteten Spektralwerten ($X_b$), um weitere Differenz-Spektralwerte ($X'_d$) zu erhalten;

Codieren der weiteren Differenz-Spektralwerte ($X'_d$) gemäß dem zweiten Codieralgorithmus, um codierte weitere Spektralwerte ($X'_{cd}$) zu erhalten.

12. Verfahren nach Anspruch 10, das ferner folgenden Schritt aufweist:
Formatieren der codierten zweiten Signale ($X_{2c}$), der codierten bewerteten Spektralwerte ($X_b$) und der codierten weiteren Differenz-Spektralwerte ($X'_{cd}$), um einen übertragbaren Datenstrom ($x_{AUS}$) zu erhalten.

13. Verfahren zum Decodieren eines codierten diskreten Signals, mit folgenden Schritten:

Decodieren von codierten zweiten Signalen ($x_{2c}$), um codierte/decodierte zweite diskrete Zeitsignale ($x_{2cd}$) zu erhalten, mittels eines ersten Codieralgorithmus;

Decodieren von codierten bewerteten Spektralwerten ($X_{cb}$) mittels eines zweiten Codieralgorithmus, um bewertete Spektralwerte ($X_b$) zu erhalten;

Transformieren der codierten/decodierten zweiten diskreten Zeitsignale ($x_2$) in den Frequenzbereich, um zweite Spektralwerte ($X_{2cd}$) zu erhalten;

inverses Bewerten der bewerteten Spektralwerte ($X_b$) und der zweiten Spektralwerte ($X_{2cd}$), um erste Spektralwerte ($X_1$) zu erhalten; und

Rücktransformieren der ersten Spektralwerte ($X_1$) in den Zeitbereich, um erste diskrete Zeitsignale ($x_1$) zu erhalten.

14. Vorrichtung zum Codieren von diskreten, mit einer ersten Abtastrate abgetasteten ersten Zeitsignalen ($x_1$), mit folgenden Merkmalen:

einer Einrichtung (12) zum Erzeugen von zweiten Zeitsignalen ($x_2$), deren Bandbreite einer zweiten Abtastrate entspricht, aus den ersten Zeitsignalen ($x_1$), wobei die zweite Abtastrate kleiner als die erste Abtastrate ist;

einer Einrichtung (14) zum Codieren der zweiten Zeitsignale ($x_2$) gemäß einem ersten Codieralgorithmus, um codierte zweite Signale ($x_{2c}$) zu erhalten;

einer Einrichtung (14) zum Decodieren der codierten zweiten Signale ($x_{2c}$) gemäß dem ersten Codieralgorithmus, um codierte/decodierte zweite Zeitsignale ($x_{2cd}$) zu erhalten, deren Bandbreite der zweiten Abtastfrequenz entspricht;

einer Einrichtung (24) zum Transformieren der ersten Zeitsignale ($x_1$) in den Frequenzbereich, um erste Spektralwerte ($X_1$) zu erhalten;

einer Einrichtung (22) zum Erzeugen von zweiten Spektralwerten ($X_{2cd}$) aus den codierten/decodierten zweiten Zeitsignalen ($x_{2cd}$), wobei die zweiten Spektralwerte ($X_{2cd}$) eine Darstellung der codierten/decodierten zweiten Zeitsignale ($x_{2cd}$) im Frequenzbereich sind und eine zu den ersten Spektralwerten ($X_1$) im wesentlichen gleiche Zeit- und Frequenzauflösung aufweisen;

einer Einrichtung (26, 28) zum Bewerten der ersten Spektralwerte ($X_1$) mit den zweiten Spektralwerten ($X_{2cd}$), um bewertete Spektralwerte ($X_b$) zu erhalten, deren Anzahl der Anzahl der ersten Spektralwerte ($X_1$) entspricht; und

einer Einrichtung (30) zum Codieren der bewerteten Spektralwerte ($X_b$) gemäß dem zweiten Codieralgorithmus, um codierte bewertete Spektralwerte ($X_{cb}$) zu erhalten.

15. Vorrichtung zum Decodieren eines codierten zeitdiskreten Signals, mit folgenden Merkmalen:

einer Einrichtung (50) zum Decodieren von codierten zweiten Signalen ($x_{2c}$), um codierte/decodierte zweite diskrete Zeitsignale ($x_{2cd}$) zu erhalten, mittels eines ersten Codieralgorithmus;

einer Einrichtung (54) zum Decodieren von codierten bewerteten Spektralwerten ($X_{cb}$) mittels eines zweiten Codieralgorithmus, um bewertete Spektralwerte ($X_b$) zu erhalten;

einer Einrichtung (64) zum Transformieren der codierten/decodierten zweiten diskreten Zeitsignale in den Frequenzbereich, um zweite Spektralwerte ($X_{2cd}$) zu erhalten;

einer Einrichtung zum inversen Bewerten der bewerteten Spektralwerte ($X_b$) und der zweiten Spektralwerte ($X_{2cd}$), um erste Spektralwerte ($X_1$) zu erhalten; und

einer Einrichtung (66) zum Transformieren der ersten Spektralwerte ($X_1$) in den Zeitbereich, um erste diskrete Zeitsignale ($x_1$) zu erhalten.

## Claims

1. A method of coding discrete first time signals ($x_1$) sampled with a first sampling rate, said method comprising the following steps:

generating second time signals ($x_2$), having a bandwidth corresponding to a second sampling rate, from the first time signal s ($x_1$), with the second sampling rate being lower than the first sampling rate;

coding the second time signals ($x_2$) in accordance with a first coding algorithm in order to obtain coded second signals ($x_{2c}$);

decoding the coded second signals ($x_{2c}$) in accordance with the first coding algorithm in order to obtain coded/decoded second time signals ($x_{2cd}$) having a bandwidth corresponding to the second sampling frequency;

transforming the first time signals ($x_1$) to the frequency domain to obtain first spectral values

($X_1$) ;

generating second spectral values ($X_{2cd}$) from the coded/decoded second time signals ($x_{2cd}$), the second spectral values ($X_{2cd}$) being a representation of the coded/decoded second time signals ($x_{2cd}$) in the frequency domain and having a time and frequency resolution substantially equal to the first spectral values ($X_1$) ;

weighting the first spectral values ($X_1$) by means of the second spectral values ($X_{2cd}$) in order to obtain weighted spectral values ($X_b$) which in number correspond to the number of the first spectral values ($X_1$) ; and

coding the weighted spectral values ($X_b$) in accordance with a second coding algorithm in order to obtain coded weighted spectral values ($X_{cb}$).

2. The method of claim 1, wherein the step of generating the second spectral values ($X_{2cd}$) comprises the following steps:

inserting a number of zero values between each discrete value of the coded/decoded second time signals ($x_{2cd}$), the number of zero values being equal to the ratio of the first to the second sampling frequency minus one, in order to obtain a modified coded/decoded second signal;

transforming the modified, coded/decoded second signal to the frequency domain to obtain modified spectral values;

selecting a range of the modified spectral values for obtaining the second spectral values ($X_{2cd}$), with said range extending from the spectral value at the lowest frequency to the spectral value whose frequency value is substantially equal to the value of the bandwidth of the second time signal ($x_2$).

3. The method of claim 1, wherein the step of generating the second spectral values ($X_{2cd}$) comprises the following steps:

inserting a number of zero values between each coded/decoded second time signals ($x_{2cd}$), the number of zero values being equal to the ratio of the first to the second sampling frequency minus one, in order to obtain a modified coded/decoded second signal;

calculating only a range of spectral values from the modified coded/decoded second signal, said range extending from the spectral value of the lowest frequency to the spectral value whose frequency is equal to the value of the bandwidth of the second time signal ($x_2$).

4. The method of claim 2 or 3,

wherein a small number of spectral lines around the frequency corresponding to the value of the bandwidth of the second time signal ($x_2$) is not selected or is weighted by means of a weighting function and selected thereafter.

5. The method of any of the preceding claims, wherein the step of weighting comprises the following steps:

subtracting the second spectral values ($X_{2cd}$) from the first spectral values ($X_1$) in order to obtain differential spectral values ($X_d$);

calculating an energy of the differential spectral values ($X_d$) ;

calculating an energy of the first spectral values ($X_1$);

frequency-selective comparing of the energies of the differential spectral values ($X_d$) and the first spectral values ($X_1$) ;

in case the energy of the differential spectral values ($X_d$) exceeds the energy of the first spectral values ($X_1$) multiplied by a factor k in a frequency section, with factor k being between 0.1 and 10,

determining the first spectral values ($X_1$) as weighted spectral values;

and otherwise, determining the differential spectral values ($X_d$) as weighted spectral values ($X_b$).

6. The method of claim 5,

wherein said frequency-selective comparison is carried out in the form of frequency groups.

7. The method of any of the preceding claims,

wherein coding of the weighted spectral values ($X_b$) according to the second coding algorithm is carried out in consideration of a psychoacoustic model.

8. The method of claim 7, wherein coding comprises the following steps:

calculating from the first time signal ($x_1$) a permissible interference energy ($E_{PM}$) in a frequency band in consideration of the psychoacoustic model;

quantizing the weighted spectral values ($X_b$) in the frequency band;

dequantizing the quantized weighted spectral values ($X_{qb}$) in the frequency band;

calculating the actual interference energy ($E_{TS}$) in the frequency band by means of the following equation:

$$E_{TS} = \Sigma(X_1[i] - (X_{qdb} + X_{2cd}))^2$$

wherein $X_1$ represents the first spectral values, $X_{qdb}$ represents the quantized/dequantized weighted spectral values, $X_{2cd}$ represents the second spectral values and i represents the summing index of a spectral value, with i encompassing the range from the first spectral value of the frequency band to the last spectral value of the frequency band;

comparing the actual interference energy ($E_{TS}$) to the permissible interference energy ($E_{PM}$) in the frequency band;

in case the actual interference energy ($E_{TS}$) is higher than the permissible interference energy ($E_{PM}$) in the frequency band, coding with finer quantizing in the frequency band; and

otherwise, coding with coarser quantizing in the frequency band.

9. The method of any of the preceding claims,

wherein coding in accordance with the second coding algorithm comprises Huffman coding for redundancy reduction.

10. The method of any of the preceding claims, comprising furthermore the following step:

formatting the coded second signals ($x_{2x}$) and the coded weighted signals ($X_{cb}$) in order to obtain a transmittable data stream ($x_{OUT}$).

11. The method of any of claims 1 to 8, which following the step of coding the weighted spectral values ($X_b$) comprises the following steps:

decoding the weighted coded spectral values ($X_{cb}$) in order to obtain coded/decoded weighted spectral values ($X_{cdb}$) ;

subtracting the coded/decoded weighted spectral values ($X_{cdb}$) from the weighted spectral values ($X_b$) in order to obtain additional differential spectral values ($X'_d$);

coding the additional differential spectral values ($X'_d$) in accordance with the second coding algorithm in order to obtain coded additional spectral values ($X'_{cd}$).

12. The method of claim 10, comprising furthermore the following step:

formatting the coded second signals ($X_{2c}$), the coded weighted spectral values ($X_b$) and the coded additional differential spectral values ($X'_{cd}$) in order to obtain a transmittable data stream ($x_{OUT}$).

13. A method of decoding a coded discrete signal, comprising the following steps:

decoding coded second signals ($x_{2c}$) to obtain coded/decoded second discrete time signals ($x_{2cd}$), by means of a first coding algorithm;

decoding coded weighted spectral values ($X_{cb}$) by means of a second coding algorithm, to obtain weighted spectral values ($X_b$) ;

transforming the coded/decoded second discrete time signals ($x_2$) to the frequency domain in order to obtain second spectral values ($X_{2cd}$) ;

inversely weighting the weighted spectral values ($X_b$) and the second spectral values ($X_{2cd}$) to obtain first spectral values ($X_1$) ; and

retransforming the first spectral values ($X_1$) to the time domain in order to obtain first discrete time signals ($x_1$).

14. An apparatus for coding discrete first time signals ($x_1$) sampled with a first sampling rate, comprising:

means (12) for generating second time signals ($x_2$), having a bandwidth corresponding to a second sampling rate, from the first time signals ($x_1$), with the second sampling rate being lower than the first sampling rate;

means (14) for coding the second time signals ($x_2$) in accordance with a first coding algorithm in order to obtain coded second signals ($x_{2c}$);

means (14) for decoding the coded second signals ($x_{2c}$) in accordance with the first coding algorithm in order. to obtain coded/decoded second time signals ($x_{2cd}$) having a bandwidth corresponding to the second sampling frequency;

means (24) for transforming the first time signals ($x_1$) to the frequency domain to obtain first spectral values ($X_1$);

means (22) for generating second spectral values ($X_{2cd}$) from the coded/decoded second time signals ($x_{2cd}$), the second spectral values ($X_{2cd}$) being a representation of the coded/decoded second time signals ($x_{2cd}$) in the frequency domain and having a time and frequency resolution substantially equal to the first spectral values ($X_1$) ;

means (26, 28) for weighting the first spectral values ($X_1$) by means of the second spectral values ($X_{2cd}$) in order to obtain weighted spectral values ($X_b$) which in number correspond to the number of the first spectral values ($X_1$); and

means (30) for coding the weighted spectral values ($X_b$) in accordance with a second coding algorithm in order to obtain coded weighted spectral values ($X_{cb}$).

15. An apparatus for decoding a coded time-discrete signal, comprising:

means (50) for decoding coded signals ($x_{2c}$) to obtain coded/decoded second discrete time signals ($x_{2cd}$), by means of a first coding algorithm;

means (54) for decoding coded weighted spectral values ($X_{cb}$) by means of a second coding algorithm, to obtain weighted spectral values ($X_b$) ;

means (64) for transforming the coded/decoded second discrete time signals ($x_2$) to the frequency domain in order to obtain second spectral values ($X_{2cd}$) ;

means for inversely weighting the weighted spectral values ($X_b$) and the second spectral values ($X_{2cd}$) to obtain first spectral values ($X_1$); and

means (66) for transforming the first spectral values ($X_1$) to the time domain in order to obtain first discrete time signals ($x_1$) .

## Revendications

1. Procédé de codage de premiers signaux discrets dans le temps ($x_1$) balayés à un premier débit de balayage, aux étapes suivantes consistant à :

générer des seconds signaux dans le temps

($x_2$), dont la largeur de bande correspond à un second débit de balayage, à partir des premiers signaux dans le temps ($x_1$), le second débit de balayage étant inférieur au premier débit de balayage ;

coder les seconds signaux dans le temps ($x_2$) selon un premier algorithme de codage, pour obtenir des seconds signaux codés ($x_{2c}$);

décoder les seconds signaux codés ($x_{2c}$) selon le premier algorithme de codage, pour obtenir des seconds signaux dans le temps codés/décodés ($x_{2cd}$) dont la largeur de bande correspond à la seconde fréquence de balayage ;

transformer les premiers signaux dans le temps ($x_1$) à la plage de fréquence, pour obtenir des premières valeurs spectrales ($X_1$) ;

générer des secondes valeurs spectrales ($X_{2cd}$) à partir des seconds signaux dans le temps codés/décodés ($x_{2cd}$), les secondes valeurs spectrales ($X_{2cd}$) étant une représentation des seconds signaux dans le temps codés/décodés ($x_{2cd}$) à la plage de fréquence et présentant une résolution de temps et de fréquence sensiblement égale aux premières valeurs spectrales ($X_1$) ;

évaluer les premières valeurs spectrales ($X_1$) avec les secondes valeurs spectrales ($X_{2cd}$), pour obtenir des valeurs spectrales évaluées ($X_b$) dont le nombre correspond au nombre des premières valeurs spectrales ($X_1$) ; et

coder les valeurs spectrales évaluées ($X_b$) selon un second logarithme de codage, pour obtenir des valeurs spectrales évaluées codées ($X_{cb}$).

2. Procédé suivant la revendication 1, dans lequel l'étape de génération des secondes valeurs spectrales ($X_{2cd}$) présente les étapes suivantes consistant à :

insérer un nombre de valeurs zéro entre chaque valeur discrète des seconds signaux dans le temps codés/décodés ($x_{2cd}$), le nombre de valeurs zéro étant égal au rapport entre la première et la seconde fréquence de balayage moins un, pour obtenir un second signal codé/décodé modifié ;

transformer le second signal codé/décodé modifié à la plage de fréquences, pour obtenir des valeurs spectrales modifiées ;

choisir une plage des valeurs spectrales modifiées, pour obtenir les secondes valeurs spectrales ($X_{2cd}$), la plage s'étendant de la valeur spectrale à la fréquence la plus petite jusqu'à la valeur spectrale dont la valeur de fréquence est sensiblement égale à la valeur de la largeur de bande du second signal dans le temps ($x_2$).

3. Procédé suivant la revendication 1, dans lequel l'étape de génération des secondes valeurs spectrales ($X_{2cd}$) présente les étapes suivantes consistant à :

insérer un nombre de valeurs zéro entre chaque second signal dans le temps codé/décodé ($x_{2cd}$), le nombre de valeurs zéro étant égal au rapport entre la première et la seconde fréquence de balayage moins un, pour obtenir un second signal codé/décodé modifié ;

calculer uniquement une plage de valeurs spectrales à partir du second signal codé/décodé modifié, la plage s'étendant de la valeur spectrale à la fréquence la plus petite jusqu'à la valeur spectrale dont la fréquence est égale à la valeur de la largeur de bande du second signal dans le temps ($x_2$).

4. Procédé suivant la revendication 2 ou 3, dans lequel un petit nombre de lignes spectrales autour de la fréquence correspondant à la valeur de la largeur de bande du second signal dans le temps ($x_2$) n'est pas sélectionné ou pondéré à l'aide d'une fonction d'évaluation et puis sélectionné.

5. Procédé suivant l'une des revendications précédentes, dans lequel l'étape d'évaluation présente les étapes suivantes consistant à :

soustraire les secondes valeurs spectrales ($X_{2cd}$) des premières valeurs spectrales ($X_1$), pour obtenir des valeurs spectrales de différence ($X_d$) ;

calculer une énergie des valeurs spectrales de différence ($X_d$);

calculer une énergie des premières valeurs spectrales ($X_1$) ;

comparer sélectivement en fonction de la fréquence les énergies des valeurs spectrales de différence ($X_d$) et des premières valeurs spectrales ($X_1$) ;

si l'énergie des valeurs spectrales de différence ($X_d$) excède l'énergie des premières valeurs spectrales ($X_1$) multipliée par un facteur k dans un segment de fréquence, le facteur k étant compris entre 0,1 et 10, déterminer les premières valeurs spectrales ($X_1$) comme valeurs spectrales évaluées ;

sinon, déterminer les valeurs spectrales de différence ($X_d$) comme valeurs spectrales évaluées ($X_b$).

6. Procédé suivant la revendication 5, dans lequel la comparaison sélective en fonction de la fréquence est effectuée par groupe de fréquences.

7. Procédé suivant l'une des revendications précédentes, dans lequel le codage des valeurs spectrales évaluées ($X_b$) est effectué selon le second algorithme de codage, en tenant compte d'un modèle psychoacoustique.

8. Procédé suivant la revendication 7, dans lequel le codage présente les étapes suivantes consistant à :

> calculer une énergie de perturbation ($E_{PM}$) permise dans une bande de fréquence, en tenant compte du modèle psychoacoustique du premier signal dans le temps ($X_1$) ;
>
> quantifier les valeurs spectrales évaluées ($X_b$) dans la bande de fréquence ;
>
> déquantifier les valeurs spectrales évaluées quantifiées ($X_{qb}$) dans la bande de fréquence ;
>
> calculer l'énergie de perturbation réelle ($E_{TS}$) dans la bande de fréquence à l'aide de l'équation suivante :

$$E_{TS} = \Sigma \ (X_1[i] - (X_{qdb} + X_{2cd}))^2$$

> où $X_1$ est les premières valeurs spectrales, $X_{qdb}$ les valeurs spectrales évaluées quantifiées/déquantifiées, $X_{2cd}$ les secondes valeurs spectrales et i l'indice d'addition d'une valeur spectrale, i allant de la première valeur spectrale de la bande de fréquences à la dernière valeur spectrale de la bande de fréquences ;
>
> comparer l'énergie de perturbation réelle ($E_{TS}$) avec l'énergie de perturbation admise ($E_{PM}$) dans la bande de fréquences ;
>
> si l'énergie de perturbation réelle ($E_{TS}$) est supérieure à l'énergie de perturbation admise ($E_{PM}$) dans la bande de fréquences, coder avec une quantification plus fine dans la bande de fréquences ; et
>
> sinon, coder avec une quantification plus grossière dans la bande de fréquences.

9. Procédé suivant l'une des revendications précédentes, dans lequel le codage selon le second algorithme de codage comporte un codage de Huffman en vue d'une réduction de redondance.

10. Procédé suivant l'une des revendications précédentes, comportant, par ailleurs, l'étape suivante consistant à formatter les seconds signaux codés ($x_{2c}$) et les signaux évalués codés ($x_{cb}$), pour obtenir un courant de données ($x_{AUS}$) pouvant être transmis.

11. Procédé suivant l'une des revendications 1 à 8, présentant, après l'étape de codage des valeurs spectrales évaluées ($X_b$), les étapes suivantes consistant à :

décoder les valeurs spectrales codées évaluées ($X_{cb}$), pour obtenir des valeurs spectrales évaluées codées/décodées ($X_{cdb}$) ;

soustraire les valeurs spectrales évaluées codées/décodées ($X_{cdb}$) des valeurs spectrales évaluées ($X_b$), pour obtenir d'autres valeurs spectrales de différence ($X'_d$) ;

coder les autres valeurs spectrales de différence ($X'_d$) selon le second algorithme de codage, pour obtenir d'autres valeurs spectrales codées ($X'_{cd}$).

12. Procédé suivant la revendication 10, présentant, par ailleurs, l'étape suivante consistant à formatter les seconds signaux codés ($x_{2c}$), les valeurs spectrales évaluées codées ($X_b$) et les autres valeurs spectrales de différence ($X'_{cd}$), pour obtenir un courant de données ($x_{AUS}$) pouvant être transmis.

13. Procédé de décodage d'un signal discret codé, aux étapes suivantes consistant à :

décoder des seconds signaux codés ($x_{2c}$), pour obtenir des seconds signaux discrets dans le temps codés/décodés ($x_{2cd}$), à l'aide d'un premier algorithme de codage ;

décoder des valeurs spectrales évaluées codées ($X_{cb}$) à l'aide d'un second algorithme de codage, pour obtenir des valeurs spectrales évaluées ($X_b$) ;

transformer les seconds signaux discrets dans le temps codés/décodés ($x_2$) à la plage de fréquence, pour obtenir des secondes valeurs spectrales ($X_{2cd}$) ;

évaluer inversement les valeurs spectrales évaluées ($X_b$) et les secondes valeurs spectrales ($X_{2cd}$), pour obtenir des premières valeurs spectrales ($X_1$) ; et

retransformer les premières valeurs spectrales ($X_1$) à la plage de temps, pour obtenir des premiers signaux discrets dans le temps ($x_1$).

14. Dispositif de codage de premiers signaux discrets dans le temps ($x_1$) balayés à un premier débit de balayage, aux caractéristiques suivantes :

un dispositif (12) destiné à générer des seconds signaux dans le temps ($x_2$), dont la largeur de bande correspond à un second débit de balayage, à partir des premiers signaux dans le temps ($x_1$), le second débit de balayage étant inférieur au premier débit de balayage ;

un dispositif (14) destiné à coder les seconds signaux dans le temps ($x_2$) selon un premier algorithme de codage, pour obtenir des seconds signaux codés ($x_{2c}$) ;

un dispositif (14) destiné à décoder les seconds signaux codés ($x_{2c}$) selon le premier algorithme de codage, pour obtenir des seconds signaux dans le temps codés/décodés ($x_{2cd}$) dont la largeur de bande correspond à la seconde fréquence de balayage ;

un dispositif (24) destiné à transformer les premiers signaux dans le temps ($x_1$) à la plage de fréquence, pour obtenir des premières valeurs spectrales ($X_1$) ;

un dispositif (22) destiné à générer des secondes valeurs spectrales ($X_{2cd}$) à partir des seconds signaux dans le temps codés/décodés ($x_{2cd}$), les secondes valeurs spectrales ($X_{2cd}$) étant une représentation des seconds signaux dans le temps codés/décodés ($x_{2cd}$) à la plage de fréquence et présentant une résolution de temps et de fréquence sensiblement égale aux premières valeurs spectrales ($X_1$) ;

un dispositif (26, 28) destiné à évaluer les premières valeurs spectrales ($X_1$) avec les secondes valeurs spectrales ($X_{2cd}$), pour obtenir des valeurs spectrales évaluées ($X_b$) dont le nombre correspond au nombre des premières valeurs spectrales ($X_1$) ; et

un dispositif (30) destiné à coder les valeurs spectrales évaluées ($X_b$) selon le second logarithme de codage, pour obtenir des valeurs spectrales évaluées codées ($X_{cb}$).

**15.** Dispositif de décodage d'un signal discret dans le temps codé, aux caractéristiques suivantes :

un dispositif (50) destiné à décoder des seconds signaux codés ($x_{2c}$), pour obtenir des seconds signaux discrets dans le temps codés/décodés ($x_{2cd}$), à l'aide d'un premier algorithme de codage ;

un dispositif (54) destiné à décoder des valeurs spectrales évaluées codées ($X_{cb}$) à l'aide d'un second algorithme de codage, pour obtenir des valeurs spectrales évaluées ($X_b$) ;

un dispositif (64) destiné à transformer les seconds signaux discrets dans le temps codés/décodés à la plage de fréquence, pour obtenir des secondes valeurs spectrales ($X_{2cd}$) ;

un dispositif destiné à évaluer inversement les valeurs spectrales évaluées ($X_b$) et les secondes valeurs spectrales ($X_{2cd}$), pour obtenir des premières valeurs spectrales ($X_1$) ; et

un dispositif (66) destiné à transformer les premières valeurs spectrales ($X_1$) à la plage de temps, pour obtenir des premiers signaux discrets dans le temps ($x_1$).

**FIG.1**

*FIG.2*

## FIG.3